Europäisches Patentamt

European Patent Office

Office européen des brevets

(19)

(11) **EP 1 382 977 A1**

(12) **EUROPEAN PATENT APPLICATION**

(43) Date of publication:
 **21.01.2004 Bulletin 2004/04**

(51) Int Cl.⁷: **G01R 31/327**

(21) Application number: **02447137.7**

(22) Date of filing: **19.07.2002**

| | |
|---|---|
| (84) Designated Contracting States:<br>**AT BE BG CH CY CZ DE DK EE ES FI FR GB GR IE IT LI LU MC NL PT SE SK TR**<br>Designated Extension States:<br>**AL LT LV MK RO SI** | • **KATHOLIEKE UNIVERSITEIT LEUVEN**<br>  **B-3000 Leuven (BE)** |
| (71) Applicants:<br>• **IMEC vzw,**<br>  **Interuniversitair Microelectronica Centrum vzw**<br>  **3001 Leven (BE)** | (72) Inventor: **van Spengen, Willem Merlijn**<br>  **1383 AS Weesp (NL)**<br><br>(74) Representative: **Van Malderen, Joelle et al**<br>  **Office Van Malderen,**<br>  **Place Reine Fabiola 6/1**<br>  **1083 Bruxelles (BE)** |

(54) **Apparatus and method for determining the performance of micro machines or microelectromechanical devices**

(57)     The present invention is related to an apparatus for determining the performances of at least one micromachined or microelectromechanical device (MEMS device) able to carry a high frequency signal having a first frequency, said device comprising a capacitive structure with at least one movable part, able to move with a second frequency, characterised in that said apparatus comprises:

- means for providing a voltage signal,
- at least one voltage divider circuit arranged between said capacitive structure and said means for providing the voltage signal,
- means for detecting and measuring the voltage at the outlet of the voltage divider.

FIG. 2a

EP 1 382 977 A1

Printed by Jouve, 75001 PARIS (FR)

## Description

## Field of the invention

The present invention is related to an apparatus and a method for determining the performance of micromachined or microelectromechanical devices (MEMS) with movable parts that handle high frequency signals. More specifically the performance parameters related to the moving behaviour of such movable devices are investigated. These movable devices are electromechanical movable devices such as MEMS switches, relays, varactors, tunable capacitors or similar.

## General description of the background of the invention

Micromachined or microelectromechanical devices can be found in a large number of applications including sensors, actuators and transducers. An example of such a field of application is wireless communication, which is expanding at an incredible pace for applications ranging from mobile phones to satellite communications. "RF MEMS" technologies are central to many parts of this expansion. The term "RF MEMS devices" designates a variety of micromachined or MEMS devices such as tunable capacitors or microswitches used in these telecommunication circuits and as such these MEMS devices are operative in a given high frequency range. These RF-MEMS components are expected to be a solution to most of the off-chip components required by state of the art high frequency transmitter and receiver systems, like antenna switches, off-chip capacitors and filters, whether tunable or not. The electrical behaviour, e.g. the capacitance value, the making of an electrical contact, of some of these "RF MEMS" devices can be tuned as these devices comprise a movable part. The ability to tune or to change the electrical characteristics of such micromachined device allows the development of reconfigurable circuits: one can alter the operating range or the selectivity of the electrical circuit by e.g. changing the capacitance value of the capacitors used in a filter, by e.g. selecting components by means of a switch. The moving action of the device can be controlled by means of an applied voltage resulting in an electrostatic force.

However before this "RF-MEMS" technology can be implemented into mainstream systems the lifetime, reliability and endurance of these movable electromechanical devices must be demonstrated. Parameters related to the switching or moving action of these MEMS devices are e.g. pull-in voltage, rise- and fall-time of the switching action, on-capacitance, off-capacitance, and drift in any of these parameters. Nowadays these devices are tested at their operation or signal frequency which can be as high as 100GHz, thereby requiring the use of complex and expensive testing tools. These testing tools need calibration and a controlled test environment, which makes it difficult to determine the characteristics of the MEMS device over the full range of the military specifications (MILSPEC). Given such testing equipment only a limited number of RF MEMS devices, most often only one, can be tested simultaneously, making it impractical to collect the large number of data needed to establish a good statistics of the characteristics of the RF MEMS device under study. In "lifetime characterisation of capacitive RF MEMS switches", published on pp 227-300 of the Proceedings of the May 2001 IEEE International Microwave Symposium held in Arizona, C. Goldsmith et Al. report on the testing of a capacitive coupled RF MEMS switch with a lifetime of 5 $10^8$ cycles. The authors use a dual-pulse actuation voltage to reduce the high voltage portion of the actuation signal and a 10 GHz continuous wave, representative for a realistic signal wave as present during operation of the device. This 10GHz signal is being multiplexed with this dual-pulse actuation voltage. The results were obtained by testing one-by-one the devices at the intended working frequency. The measurements were hence expensive and time-consuming and statistically relevant lifetime distribution cannot be obtained given the limited number of devices tested.

Accordingly, there is a need for the development of cheap lifetime testing equipment, which allows a time-efficient and statistical relevant measurement of the lifetime distribution of high frequency micromachined devices, such a solution would have a large commercial value.

## Aims of the invention

The present invention aims to offer an apparatus and a method which do not have the drawbacks of the state of the art, for determining the performances and in particular for testing the lifetime properties of micromachined or microelectromechanical devices (MEMS) comprising at least one movable part or element. In particular, said movable part which can be a capacitor or a switch which is operative at a frequency above 100MHz.

A particular aim of the invention is to considerably shorten the time needed to establish a statistical significant dataset to determine the lifetime or reliability behaviour of such high frequency MEMS devices.

A further aim of the invention is to allow the use of standard testing equipment for testing such high frequency MEMS devices, as such standard testing equipment operating at room conditions, such as temperature and humidity, without the need for extensive calibration.

A further aim of the invention is to enable the parallel or simultaneous measurement of multiple high frequency MEMS devices under test.

A further aim of the invention is to enable testing of such high frequency MEMS devices in a broad range of environmental conditions e.g. at an elevated temperature and/or at high humidity levels.

## Summary of the invention

In a first aspect of the invention an apparatus for determining switching characteristics of at least one high frequency MEMS device is disclosed. This high frequency device comprises a capacitive structure with at least two parts relative movable towards each other. The apparatus comprises supply means for generating a combined voltage comprising an actuation voltage for varying the relative position of these at least two movable parts and a measurement voltage, means for providing this combined voltage signal to this at least one high frequency MEMS device. The apparatus further comprises at least one voltage divider circuit capable of receiving this at least one high frequency MEMS device and the combined voltage is applied to this voltage divider circuit resulting in an amplitude modulation of the measurement voltage by varying the relative position of these at least two movable parts.

This apparatus further comprises means for detecting the envelope of said amplitude modulated measurement voltage.

This apparatus further comprises means for digitally selecting this at least one voltage divider circuit from an array of voltage divider circuits. These digitally selecting means include means for selecting at least two of said voltage divider circuits simultaneously from said array of voltage divider circuits.

In a second aspect of the invention a method is disclosed for determining switching characteristics of at least one high frequency MEMS device. In operation this MEMS device transmits or conducts a high frequency signal having a signal frequency above 100MHz or even above 1GHz. This high frequency (HF) MEMS device comprises a capacitive structure with at least two parts relative movable towards each other and this high frequency MEMS device is arranged in a voltage divider. The method comprises the steps of applying a combined voltage signal to this HF MEMS device, whereby this combined voltage comprises an actuation voltage for varying the relative position of these at least two movable parts, whereby the actuation voltage has an actuation frequency below the signal frequency and a measurement voltage. The HF MEMS device is arranged in this voltage divider such that the variation the relative position of these at least two movable parts results in an amplitude modulation of the measurement voltage

Preferably, the relative position of said at least two movable parts is varied between two predetermined values. The envelope of said amplitude modulated measurement voltage has two extreme values. Each of these two extreme values respectively corresponds to one of these two predetermined relative positions, and the difference between these two values of the envelope is indicative for switching characteristics of the high frequency MEMS device. Alternatively each of these two extreme values respectively corresponds to one of these two predetermined relative positions, and the time required to vary the value of the envelope between these two extreme values is indicative for switching characteristics of the high frequency MEMS device.

In a preferred embodiment of the first aspect the high frequency MEMS device is an RF MEMS switch transmitting or carrying a signal having a signal frequency in the range of 100MhZ to 10GHz. The frequency of the actuation voltage is in the range of 1kHz to 200KHz, while the measurement voltage has a frequency in the range of 1 MHz to 50MHz.

In another embodiment of the first aspect the methods further comprises the step of digitally selecting the high frequency MEMS device from an array of high frequency MEMS devices. Instead of selecting only one high frequency MEMS device at the time, more then one high frequency devices can be selected and measured in parallel.

## Brief description of the drawings

All drawings are intended to illustrate some aspects and embodiments of the present invention. Devices are depicted in a simplified way for reason of clarity. Not all alternatives and options are shown and therefore the invention is not limited to the content of the given drawings. Like numerals are employed to reference like parts in the different figures.

Figure 1 is describing a schematic view of a prior art RF MEMS switch as an example of a micromachined device with at least one movable part.

Figures 2 a-d are representing schematic views of the device under test according to the method of the present invention.

Figures 3a-d are representing the characteristics of an example of the voltage signals (V) used or generated according to the invention as function of time t (s): input signal (fig 3a), output signal (fig 3b), filtered output signal (fig 3c), envelope signal (fig 3d).

Figures 4a-d are showing a schematic view of the equipment set-up (fig 4a) according to the present invention with details of the detection unit (fig 4b), the adder circuit (fig 4c) and the envelope detector (fig 4d) respectively.

Figures 5a and 5b are representing examples of two characteristic signals according to preferred embodiments of the present invention.

## Detailed description of preferred embodiments of the present invention

In relation to the appended drawings the present invention is described in detail in the sequel. It is apparent however that a person skilled in the art can imagine several other equivalent embodiments or other ways of executing the present invention, the spirit and scope of the present invention being limited only by the terms of the appended claims.

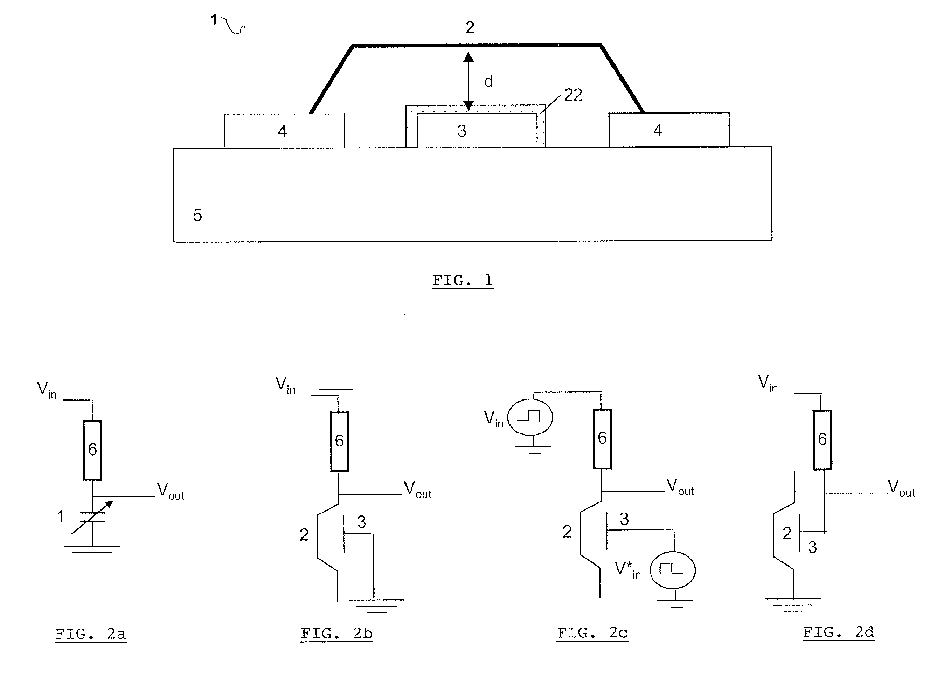

A schematic cross-sectional view of a RF MEMS switch (1) is given in figure 1. Examples of such capacitive microelectromechanical switches can be found in WO 02/01584 A1, hereby incorporated by reference in its entirety. In such figure 1 an example of a micromachined device is described. Such device (1) has at least one movable part with comprises a first element (2) and a second element (3). Both elements can move relative to each other: the first element (2) can be e.g. a membrane or a cantilever that is movable while the second element (3) is a reference element that is either fixed or movable. The fixed element (3) can be part of the substrate (1) on or in which the micromachined device (1) is formed. Each of both elements (2,3) can be considered as being one of the two electrodes of a capacitor so both elements are capacitively coupled. If each (2,3) of both elements comprise at least one conductive layer the capacitance between both elements (2,3) can be determined. Typically the relative movement of both elements results from an electrostatic force generated by a voltage applied between both elements, each comprising a conductive layer. For the purpose of teaching the invention an RF MEMS switch is used as an example of such a micromachined device (1) comprising at least one movable part which in operation transmits a high frequency signal, while the RF MEMS switch switches at a given frequency. The scope of the invention is however not limited to a RF MEMS switch only, but includes all micromachined devices with movable parts electrically operating at high frequencies. Other capacitive structures comprise e.g. a single movable plate (2) positioned in between two fixed plates (3) to which the single movable plate (2) is capacitively coupled. With high frequencies is meant, within the scope of this invention, frequencies above the 100Mhz, preferably above 1GHz.

According to a preferred embodiment, the first element (2) is a bridge, typically made of a metal, positioned above the second element (3) which is in this example the signal line (3) situated in between the ground lines (4) of a coplanar wave guide (CPW). The switch is formed on a substrate (5), which is typically a glass, a high-resistive silicon substrate or quartz plate. In this example the conductive signal line (3) is covered with a dielectric (22) to avoid an ohmic contact between the conductive bridge (2) and the conductive signal line being the bottom electrode (3) of the associated capacitive structure. Such switch is also known as a Metal-Insulator-Metal switch (MIM) or capacitively coupled switch. In normal operation a high frequency signal will be carried along the signal path (3) as long as the switch is open, which in figure 2 would be the up position. If however the bridge (2) is pulled down, which in figure 2 would be the down position, the signal travelling or carried along the signal path (3) will be short-circuited to ground because the signal line (3) is, in this position of the bridge (2), strongly capacitively coupled, via the bridge (2), to the ground lines (4) of the coplanar wave guide shown in figure 2. When electro statically activating the bridge (2) with a high voltage signal having a given switching frequency the signal path of the high frequency data signal can be interrupted.

In a first aspect of the invention a method is disclosed to measure the switching characteristics of the micromachined device with a movable part under test.

A schematic view of the measurement set-up comprising the RF MEMS switch (1) under test is given in figure 2a. The RF MEMS switch (1) is part of a voltage divider comprising an impedance that remains constant during the measurement or is even frequency-independent, e.g. a resistor (6) having an impedance $Z_r$, and wherein the RF MEMS switch (1) acts as an impedance, variable during the measurement, having an impedance $Z_c$. The output voltage $V_{out}$ measured across the RF MEMS switch (1) is related to the input voltage $V_{in}$ applied to the voltage divider, as follows:

$$V_{out} = V_{in} \frac{Z_c}{Z_r + Z_c} \text{ whereby } Z_c = \frac{d}{2\pi f_{meas} A \varepsilon}$$

In this expression A is the area of the capacitance between the first (2) and second (3) elements of the RF MEMS switch (1), s is the dielectric constant of the medium in between the first (2) and second (3) element. If the switch (1) is open, the distance d between the bridge (2) and the signal line (3) has its maximum value and correspondingly the impedance $Z_c$ has it highest value. Hence the output voltage $V_{out}$ is a large fraction of the input voltage $V_{in}$. If the RF MEMS switch (1) is actuated the bridge (2) approaches the signal line (3) and hence the distance d is lowered. The impedance $Z_c$ decreases and the output voltage $V_{out}$ becomes a smaller fraction of the input voltage $V_{in}$. Figure 2b shows a connection of the RF MEMS switch. The bridge (2) is connected to the resistor (6) at least at one terminal. The other terminal can be left floating or connected to the resistor (6) as well. The bottom electrode (3), being the signal line as illustrated in figure 1, is connected to a fixed voltage, in this example the ground. The bottom electrode (3) can be connected to a variable voltage source V*in, as shown in figure 2c. Figure 2d shows an alternative set-up which is used in a preferred embodiment wherein the bridge (2) is connect to ground or to a fixed voltage, while the bottom electrode (3), being the signal line, is connected to the resistor (6). The input voltage $V_{in}$ is applied to the signal line (3), which is connected in series with the impedance (6). The output voltage $V_{out}$ is taken from this signal line (3) at a position between the impedance (6) and the RF MEMS switch (1). Once could say that the input voltage $V_{in}$ travels along the signal path.

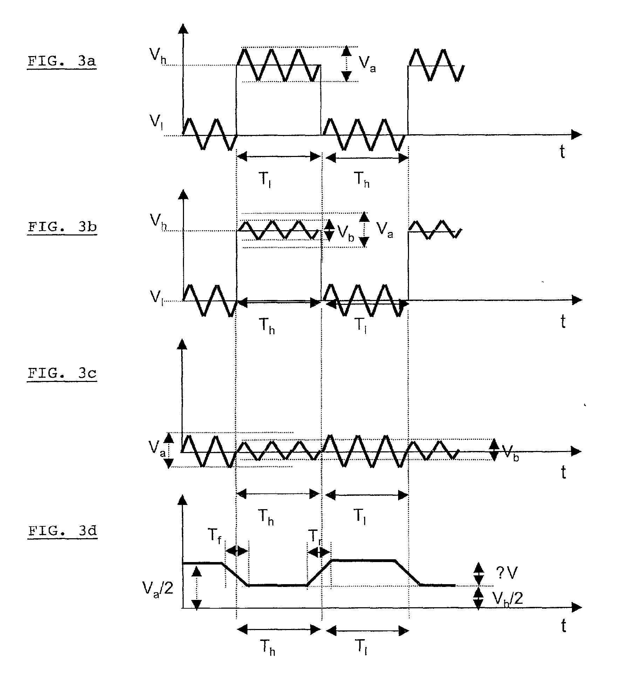

The input voltage $V_{in}$ comprises two signals as shown in figure 3a: a first voltage signal $V_{act}$ (thin line) actuating the moving part, i.e. the switch (2), and a second voltage signal $V_{meas}$ (thicker line) used to detect the switching characteristics of the RF MEMS switch (1).

The first voltage signal is typically at a first, lower, frequency such that at this actuation frequency of the first voltage signal the variable impedance of the RF MEMS switch (1) is considered as an open circuit. The first voltage signal can be any periodic signal whose amplitude varies between a first low level $V_l$ and a first high level $V_h$. The first low level $V_l$ is below the actuation voltage of the switch and it brings the switch in a first position. Typically this first low level $V_1$ is 0 V. The first high level $V_h$ is situated above the actuation voltage of the device under study and forces the switch to a second position. In this example the first position is the up-position of the bridge (2) while the second position is the down-position where the bridge (2) touches the bottom electrode (3). The duty cycle of the actuation voltage, i. e. the ratio between the downtime and the sum of downtime and uptime, depends on the application the MEMS device is intended for. In case a single pulse is to be examined, then the duty cycle is very low, while for periodic signals the associated uptime $T_h$ and downtime $T_l$ of the switch are substantially of the same value. The downtime is typically higher than the sum of risetime and falltime of the actuation voltage. A preferred example of such first voltage signal is a block wave, square wave or single pulse wave, with a duty cycle of about 50%. The frequency of the first voltage signal is in the range of 1 to 200kHz, preferably in the range of 1Hz tot 40kHz, more preferably in the range of 1kHz to 40KHz. The frequency of the first signal can be kept constant during the measurement period but can be changed, e.g. be increased or decreased with a given factor. As shown in figure 2c the first input signal can be the combination of the input signal $V_{in}$ and an input signal $V^*_{in}$ of the opposite sign. This has the advantage that the absolute value of both signals $V_{in}$ and $V^*_{in}$ can be kept limited while the amplitude of their sum ($V_{in} + V^*_{in}$) exceeds the actuation voltage of the switch.

The second voltage signal is a signal at a second frequency, which is high compared to the frequency of the actuation voltage. This second frequency, also called measurement frequency, must be high enough in order to obtain a low enough value of the variable impedance (1) as the impedance of the RF MEMS device decreases with frequency. If the second frequency is too low the associated impedance of the RF MEMS device (1) is high and correspondingly a high value of the resistor (6) must be selected: consequently a high impedance network is created which would make the detection of the output signal difficult. The frequency of the second voltage signal must be chosen such that the difference in the capacitance between the "on" or "down" and the "off" or "up" position of the MEMS RF switch (1) results in a measurable change in amplitude of the high frequency component of the output signal. The second frequency must be high enough to be able to detect the variation in slope of the envelope signal indicative of the switching characteristics, as explained further on. Typically the frequency of the second voltage signal is 100 times higher than the frequency of the first voltage signal.

On the other hand this second frequency must substantially below the signal frequency of the signals passing through or transmitted by the RF MEMS switch (1) during operation. This signal frequency depends on the application for with the micromachined device is used, but in case of RF MEMS switches (1) this signal frequency is higher than 100MHz and can range from 1GHz to 100GHz or higher. The frequency of the second voltage signal, i.e. the measurement frequency, is typically between 1 MHz and 50 MHz, preferably between 10 and 20MHz. This measurement frequency must be sufficient for detecting the main features of the switch cycle such as pull-in voltage, rise- and fall-time of the switching action, on-capacitance, off-capacitance, and drift, i.e. variation in time or with number of switching cycles, in any of these parameters so as to study the degradation mechanisms and to detect a complete failure of the RF MEMS switch (1). The second voltage is preferably a periodic signal, such as a (co)sinusoidal, triangular wave, saw tooth wave or alike. The amplitude $V_a$ of the second voltage signal must be large enough to be detectable but not to large as to influence the up or down state of the RF MEMS switch (1). Typically the amplitude $V_a$ is in the range from 100mV to 2V.

When the switch is actuated by the first voltage signal $V_{act}$ the impedance of the RF MEMS switch (1) will vary. The amplitude of the second voltage $V_{meas}$ will be varied also by the operation of the voltage divider. As shown in figure 3b the output voltage $V_{out}$ also comprises two signals: a low frequency signal corresponding to the actuation voltage $V_{act}$ (thin line) which is essentially unaffected and an amplitude modulated measurement voltage $V^*_{meas}$ (thick line) whose amplitude is e.g. being affected during the down time $T_l$ i.e. when the switch is closed. As shown in figure 3b the amplitude of the modulated second voltage signal $V^*_{meas}$ is lowered from the value $V_a$ when the bridge (2) is at maximum distance from the bottom electrode (3) to a value $V_b$. In normal operation the high frequency or RF signal is short-circuited to the ground when the switch is in its down-position. Apart from the absence of a high frequency signal no information of the switching characteristics is obtained during this down time as the RF signal is blocked. In the present invention the amplitude modulation of the modulated second voltage signal $V^*_{meas}$ due the relative displacement of the movable part in both the up and down time of the switch is used to study the switching characteristics of the device as function of number of switching cycles or movements.

In an embodiment of the invention only the amplitude modulated part $V^*_{meas}$ or high frequency part of the output signal is considered. As shown in figure 3c the low frequency first signal voltage is removed from the output signal leaving only the modulated second voltage signal $V^*_{meas}$. In the second aspect of the invention various alternatives to perform this filtering are presented. Further processing of the filtered output signal is done to yield an electrical signal $V_{dem}$ indicative to the switching characteristics of the RF MEMS switch (1). From this signal one can determine e.g. if the switching action is ongoing or if the device failed shows no amplitude modulation. As explained in the second aspect of the invention the envelope of the modulated second voltage signal $V^*_{meas}$ contains information regarding the switching performance of the RF MEMS switch (1). Figure 3d shows this envelope signal $V_{dem}$ after filtering and demodulation the output signal. The value of the amplitude of the envelope signal varies between half the value of the amplitudes $V_a$ and $V_b$ of the modulated second voltage signal $V^*_{meas}$ in the corresponding up ($T_h$) and down ($T_l$) time of the switch. Because the change from one position to a second position takes a definite amount of time the envelope signal is characterised by a fall time $T_f$, when the switch is being pulled down by the actuation voltage and by a rise time $T_r$ when the switch is being released. From the difference in amplitude ($\Delta V$) between the up and down position the change in capacitance of the RF MEMS switch (1) during the switching cycle can be determined. As long as this difference in amplitude remains constant the RF MEMS device (1) switches properly. Any change in this amplitude difference points to a wear-out of the switching performance. Depending on the material choice the switching action results in a weakening of their mechanical strength and finally no amplitude difference is observed when the RF MEMS switch has finally failed. If the bridge (2) would partially stick to the bottom electrode (3) this would result in a change of the amplitudes $V_a$ and $V_b$ of the modulated second voltage signal $V^*_{meas}$ which will be reflected in the envelope signal. If the response of the switch to the actuation voltage is delayed, e.g. to wear out, the fall time $T_f$ and rise time $T_r$ will vary over time. From this it is clear that information of the amplitude modulated second voltage signal during both the up and down time of the switch is used to study the switching performance.

In a second aspect of the invention an apparatus is disclosed to measure the switching characteristics of the micromachined device under test.

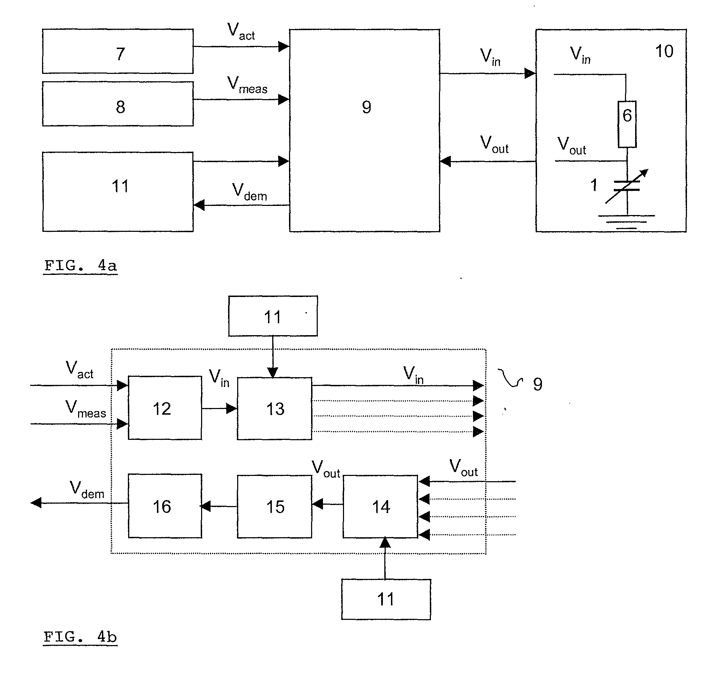

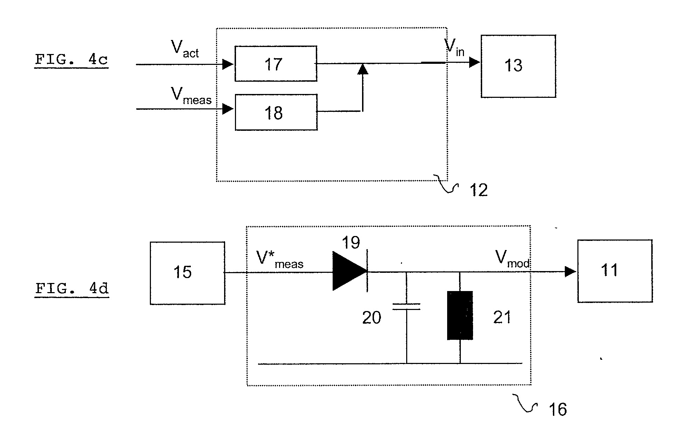

A schematic equipment set-up for the assessment of lifetime tests of micromachined devices comprising movable parts, such as RF MEMS switches is shown in Figure 4a. The equipment set-up comprises a first generator (7) supplying the first voltage signal or actuation voltage $V_{act}$, a second generator (8) supplying the second voltage signal or measurement signal $V_{meas}$, a computer (11) for controlling the operation of the equipment set-up, a detection unit (9) and a test board (10). The test board comprises the RF MEMS switch (1) configured in a voltage divider arrangement as illustrated in figure 2a and 2b. The detection unit (9) combines the first and the second voltage signal to an input signal $V_{in}$ that is applied to the devices-under-test (1), while the computer (10) selects the device or devices to be tested. The detection unit (9) collects the output signal $V_{out}$ of the device(s) under test and yields the characteristic electrical signal $V_{dem}$ that can be transmitted to the computer (11) for further processing or data storage or acquisition.

Figure 4b gives a detailed view of such detection unit (9). The first and second voltage signals are combined e.g. in an adding circuit (12). The combined signal can optionally be amplified and is then supplied to test board (10). If more than 1 device (1) needs to be tested, a first switching matrix (13) is foreseen. Under control of the computer (11) this first switching circuit (13) can select the device or devices on the test board (10) to be tested. More than one device (1) can be tested or monitored in parallel with the others. If needed buffers can be inserted to provide sufficient power to multiplexed signal in order to drive all the devices (1) to be tested simultaneously without degradation of the input signal $V_{in}$, although the use of such buffers has some drawbacks as explained later on. The output signal of the monitored device or devices is sent to the detection unit (9). A second switching matrix (14) is foreseen to collect the output signal of the device or devices that are being tested. The sampled output signals are fed into a filter (15), e.g. a band pass filter, to remove the actuation voltage $V_{act}$ being the low frequency part of the output signal, yielding only the high frequency part $V^*_{meas}$ of the output signal. This high frequency part is then processed in a circuit (16) resulting in an electrical signal $V_{dem}$ related to the switching characteristics of the RF MEMS switch (1). This electrical signal $V_{dem}$ can then be collected by the computer (11). Depending on the set-up multiple devices-under-test (1) can be addressed simultaneously and monitored one-at-a-time or multiple devices-under-test (1) in parallel as is illustrated by the dashed arrows in figure 4b.

The circuit (16) generating the electrical signal $V_{dem}$ can comprise an amplitude modulation detector. This amplitude modulation detector can be a simple envelope detector of the series type, e.g. comprising a diode (19) and a resistor (21) -capacitor (20) filter as illustrated in figure 4d, or a more elaborate set-up using a homodyne or heterodyne detector unit with zero intermediate frequency as is known and appreciated by a person skilled in the art. The resulting signal $V_{dem}$ can be considered as the envelope of an amplitude modulated (AM) signal $V^*_{meas}$. The high frequency signal $V_{meas}$ can be considered as the carrier signal of an AM signal, which is much higher in frequency then the lower frequency signal $V_{act}$ which can be considered as the message signal of the amplitude modulated wave.

In a preferred embodiment of the second aspect the combining of the first and second voltage signal is outlined. The combined signal $V_{in}$ can be generated in several ways. One way is an adder circuit comprising active components. With active components is meant for example transistors, integrated circuits and alike.

These active components can also be used in the adder circuit itself or in the subsequent amplifiers. However these active components inherently introduce non-linearities in the combined and amplified signal $V_{in}$ causing the combined signal to become already somewhat amplitude modulated before supplying the input signal to the switch. To circumvent this problem with active electronics, a different approach is illustrated in figure 4c. The low frequency first voltage signal $V_{act}$ passes through a filter i.e. a resonance circuit (17) comprising passive components, e.g. a parallel connection of a capacitor and a coil. This resonance circuit (17) blocks the high frequency second voltage signal $V_{meas}$ coming from the second generator (8). The high frequency second voltage signal $V_{meas}$ also passes trough a filter (18), in this case a ceramic filter, while this filter (18) blocks the high voltage low frequency actuation signal $V_{act}$ coming from the first generator (7). By using these passive components to respectively transmit one signal and block the other signal both signals can be put on the same voltage line without reversely effecting the first and second voltage generators (7,8). The use of passive components such as resistors, capacitors and coils, but ceramic filters are also considered passive because they have no amplifying parts, results in negligible amplitude modulation prior to the switch. Essentially all amplitude modulation measured in the output signal $V_{out}$ stems from the switching action of the RF MEMS switch (1) or phenomena associated with changes in the capacitance of the RF MEMS switch (1) such as e.g. changes in the dielectric on top of the bottom electrode (3).

At the output terminal of the test board (10) or of the switching matrix (14) again a band-pass ceramic filter (15) can be used to block the high voltage actuation voltage, which could destroy or at least interfere with the normal operation of the detector circuit (16). After passing this filter (15) the high frequency modulated signal $V^*_{meas}$ can be optionally amplified using active components.

In an example illustrating the present invention the following parameter values were used :

- a first voltage signal $V_{act}$ was a square wave with a low level $V_l$ of 0 V and a high level $V_h$ of 50V with an actuation frequency of 1kHz and a duty cycle of 50%. The first position of the bridge (2) is being open and at maximum distance from the bottom electrode (3) while the second position of the switch is closed and in direct contact with the bottom electrode (3).
- A second voltage signal $V_{meas}$ was a sinus wave with a frequency of 10.7MHz and an amplitude of 1V.
- The change in impedance value for the variable impedance $Z_c$ of the RF MEMS switch (1) at 10 MHz was between 0.1pF and 10 pF.
- 16 RF MEMS switches (1) can be put on the same test board and they can be selectively tested under control of the computer

- The devices under test (1) were switched in a logarithmic order and the testing was done automatically after 10, 20, 50, 100, 200, .. cycles upto $20 \cdot 10^8$ cycles which corresponds to a total test time of 5.8 days.
- devices were tested at room temperature or at 125°C

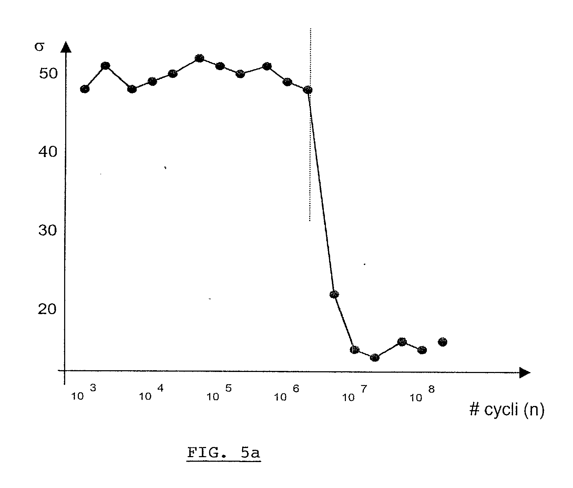

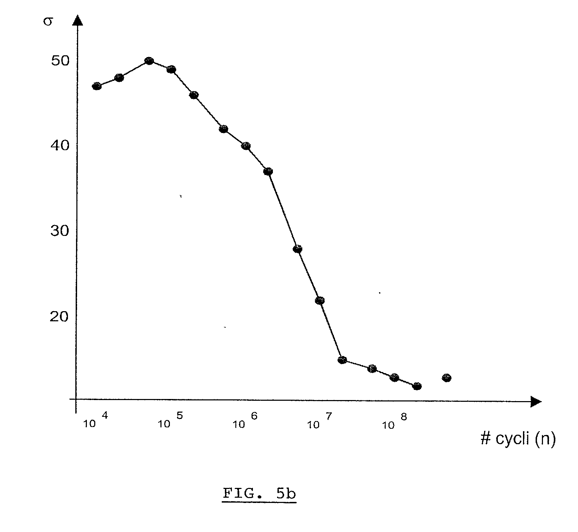

Figures 5a and 5b are examples of such an envelope signal. On the horizontal axis the number "n" of switching cycles is given on a logarithmic scale, while on the vertical axis the standard deviation on the amplitude of the detector signal $V^*_{meas}$ is given, instead of the amplitude or difference ($\Delta V$) itself. Figure 5a shows the performance of a good switch that can be activated about $2 \cdot 10^6$ times before starting to fail, as indicated by the sudden decrease in signal. Figure 5b shows the performance of a bad device, that already starts to fail from $10^5$ cycles on as indicated by the gradually decrease of the signal with increased switching actions.

## Claims

1. An apparatus for determining the performances of at least one micromachined or microelectromechanical device (MEMS device) able to carry a high frequency signal having a first frequency, said device comprising a capacitive structure with at least one movable part, able to move with a second frequency, said apparatus comprising at least the following:

   - means for providing a voltage signal,
   - at least one voltage divider circuit comprising, in series with said means for providing the voltage signal, an impedance, an outlet and said capacitive structure,
   - means for detecting and measuring the voltage at the outlet of the voltage divider,

   **characterised in that** the means for providing the voltage signal are arranged for providing a combined voltage signal of an actuation voltage able to act on the moveable part of the of the capacitive structure with a third frequency and of a measurement voltage, said measurement voltage having a fourth frequency lower than the first signal frequency.

2. An apparatus according to claim 1, wherein the actuation voltage has a third frequency in the same range of the second frequency of the movable part and is preferably equal to said second frequency.

3. An apparatus according to claim 2, wherein said third and second frequency are in the range of 1 kHz to 200 kHz.

4. An apparatus according to any one of the preceding claims, wherein said MEMS device is an RF MEMS switch with first frequency in a frequency range of 100 MHz to 10 GHz.

5. An apparatus according to any one of the preceding claims wherein the fourth frequency of the measurement voltage is in the frequency range of 1 MHz to 10 MHz.

6. An apparatus according to any one of the preceding claims, wherein the movable part is consisting of at least two movable elements having a relative position between two predetermined values.

7. An apparatus according to any one of the preceding claims wherein a series of voltage divider circuits are arranged in an array with a series of the capacity structure of several MEMS devices.

8. An apparatus according to claim 7, wherein further comprising means for digitally selecting at least one voltage divider circuit from an array of voltage divider circuits.

9. An apparatus according to claim 8, wherein said means for digitally selecting said at least one voltage divider circuit includes means for selecting at least two of said voltage divider circuits simultaneously from said array of voltage divider circuits.

10. A method for determining the performances of at least one micromachined or microelectromechanical device (MEMS device), capable of carrying a high frequency signal having a first frequency, and comprising a capacitive structure with at least one movable part, able to move with a second frequency, comprising the steps of:

   - providing a voltage signal,
   - applying said voltage signal to at least one voltage divider circuit comprising, in series with said means for providing the voltage signal, an impedance, an outlet and said capacitive structure,
   - detecting and measuring the voltage at the outlet of the voltage divider,
   - wherein said voltage signal is a combined voltage signal of an actuation voltage able to act on the moveable part of the capacity structure with a third frequency and a measurement voltage, said measurement voltage having fourth frequency lower than the first signal frequency.

11. A method according to claim 10, wherein the step of detecting and measuring comprises the step of analysing the envelope of the amplitude modulated measurement voltage at the outlet of the voltage divider.

12. A method according to claim 10 and 11, wherein the actuation voltage has third frequency in the same range than the second frequency of the movable part.

13. A method according to claim 10 and 11, wherein said actuation voltage has a third frequency in the range of 1 kHz to 200 kHz.

14. A method according to claim 10 and 11, wherein said MEMS device is an RF MEMS switch with first frequency in a frequency range of 100 MHz to 10 GHz.

15. An apparatus according claim 10 or 11 wherein the fourth frequency of the measurement voltage is in the frequency range of 1 MHz to 10 MHz.

16. A method according to claim 10 and 11, wherein the movable part is consisting of at least two movable elements having a relative position between two predetermined values.

EP 1 382 977 A1

1

2

d

22

4

3

4

5

FIG. 1

$V_{in}$

6

1

$V_{out}$

FIG. 2a

$V_{in}$

6

2

3

$V_{out}$

FIG. 2b

$V_{in}$

$V_{in}$

6

2

3

$V_{out}$

$V^*_{in}$

FIG. 2c

$V_{in}$

6

2

3

$V_{out}$

FIG. 2d

EP 1 382 977 A1

FIG. 3a

FIG. 3b

FIG. 3c

FIG. 3d

FIG. 4a

FIG. 4b

FIG. 4c

FIG. 4d

FIG. 5a

FIG. 5b

**European Patent Office**

## EUROPEAN SEARCH REPORT

Application Number

EP 02 44 7137

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 5 506 454 A (HANZAWA KEIJI ET AL) 9 April 1996 (1996-04-09) * figures 1-4 * * column 3, line 25 - column 6, line 59 * | 1-3, 10-13 | G01R31/327 |
| A | | 4-9, 14-16 | |
| A | WO 00 02110 A (VALTION TEKNILLINEN ;OJA AARNE (FI); SEPPAE HEIKKI (FI); SUHONEN M) 13 January 2000 (2000-01-13) * figure 9 * * page 13, line 23 - page 15, line 25 * | 1-16 | |
| A | US 5 211 051 A (KAISER WILLIAM J ET AL) 18 May 1993 (1993-05-18) * figures 1,5 * * column 3, line 34 - column 9, line 2 * * column 11, line 55 - column 12, line 47 * | 1-16 | |
| A | EP 0 639 755 A (VAISALA OY) 22 February 1995 (1995-02-22) * figures 7,8 * * page 6, line 5 - line 26 * | 1-16 | TECHNICAL FIELDS SEARCHED (Int.Cl.7) G01R B81C H01H |

The present search report has been drawn up for all claims

| Place of search | Date of completion of the search | Examiner |
|---|---|---|
| BERLIN | 29 November 2002 | Polesello, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**            EP 02 44 7137

This annex lists the patent family members relating to the patent documents cited in the above-mentioned European search report.
The members are as contained in the European Patent Office EDP file on
The European Patent Office is in no way liable for these particulars which are merely given for the purpose of information.

29-11-2002

| Patent document cited in search report | | Publication date | Patent family member(s) | | Publication date |
|---|---|---|---|---|---|
| US 5506454 | A | 09-04-1996 | JP | 2761303 B2 | 04-06-1998 |
| | | | JP | 4292242 A | 16-10-1992 |
| | | | JP | 5322921 A | 07-12-1993 |
| | | | DE | 4209140 A1 | 24-09-1992 |
| | | | DE | 4244901 C2 | 18-09-1997 |
| | | | KR | 221798 B1 | 15-09-1999 |
| | | | US | 5387819 A | 07-02-1995 |
| | | | DE | 4316263 A1 | 25-11-1993 |
| WO 0002110 | A | 13-01-2000 | WO | 0002110 A2 | 13-01-2000 |
| US 5211051 | A | 18-05-1993 | US | 5265470 A | 30-11-1993 |
| | | | US | 5449909 A | 12-09-1995 |
| | | | US | 5293781 A | 15-03-1994 |
| | | | US | 5315247 A | 24-05-1994 |
| | | | US | 5290102 A | 01-03-1994 |
| EP 0639755 | A | 22-02-1995 | FI | 93579 B | 13-01-1995 |
| | | | CA | 2130364 A1 | 21-02-1995 |
| | | | DE | 69414783 D1 | 07-01-1999 |
| | | | DE | 69414783 T2 | 29-07-1999 |
| | | | EP | 0639755 A2 | 22-02-1995 |
| | | | JP | 7092046 A | 07-04-1995 |
| | | | NO | 943069 A | 21-02-1995 |
| | | | US | 5531128 A | 02-07-1996 |

EPO FORM P0459

For more details about this annex : see Official Journal of the European Patent Office, No. 12/82